## Europäisches Patentamt
## European Patent Office
## Office européen des brevets

(19)

(11) Veröffentlichungsnummer: **0 005 743**
**B1**

(12) **EUROPÄISCHE PATENTSCHRIFT**

(45) Veröffentlichungstag der Patentschrift: **13.01.82**

(21) Anmeldenummer: **79101386.5**

(22) Anmeldetag: **07.05.79**

(51) Int. Cl.³: **G 11 C 7/00,** G 11 C 11/40, H 01 L 27/02

(54) Schaltung zum Nachladen des Ausgangsknotens einer Feldeffekt-Transistorschaltung und Anwendung der Schaltungsanordnung als Lastelement in einem Flip-Flop.

(30) Priorität: **06.06.78 DE 2824727**

(43) Veröffentlichungstag der Anmeldung:
**12.12.79 Patentblatt 79/25**

(45) Bekanntmachung des Hinweises auf die Patenterteilung:
**13.01.82 Patentblatt 82/2**

(84) Benannte Vertragsstaaten:
**DE FR GB**

(56) Entgegenhaltungen:
**DE - A - 2 722 757**
**DE - A - 2 734 987**
**DE - B - 2 361 823**

(73) Patentinhaber: **International Business Machines Corporation**
**Armonk, N.Y. 10504 (US)**

(72) Erfinder: **Haug, Werner**
**Pontoiser Strasse 43**
**D-7030 Böblingen (DE)**
Erfinder: **Gschwendtner, Jörg**
**Seitenstrasse 38**
**D-7300 Esslingen (DE)**
Erfinder: **Schnadt, Robert**
**Keilbergstrasse 1**
**D-7030 Böblingen (DE)**

(74) Vertreter: **Neuland, Johannes, Dipl.-Ing.**
**Schönaicher Strasse 220**
**D-7030 Böblingen (DE)**

Schaltung zum Nachladen des Ausgangsknotens einer Feldeffekt-Transistorschaltung und Anwendung der Schaltungsanordnung als Lastelement in einem Flip-Flop

Die Erfindung bezieht sich auf eine Schaltung zum Nachladen des Ausgangsknotens einer Feldeffekt-Transistorschaltung gemäßdemersten Teil des Anspruchs auf und eine Veriwendung der Schaltung als Lastelement in einem Flip-flop. Eine derartige Schaltung ist aus der DE—A—2 722 757 betannt.

Feldeffekt-Transistoren, im folgenden kurz als FET bezeichnet, werden wegen ihres vergleichsweise geringhen Platzbedarfes gerne zum Aufbau monolithisch integrierter Halbleiter herangezogen. Da diese Speicher beim Auslesen nur verhältnismäßig schwache Lesesignale abgeben, erfordern sie besondere Leseverstärker. Ein derartiger Leseverstärker ist aus der Deutschen Offenlegungsschrift 27 22 757 bekannt, in der er als dynamischer Lese-Auffrischdetektor bezeichnet wird. Mit den Eingangs-/Ausgangsanschlüssen der bekannten Schaltungsanordnung sind zwei Last-Affrischschaltungen sowie eine Spannungs-Ausgleichsschaltung verbunden. Letztere dient im Betrieb des Speichers dazu, die Potentiale der beiden Eingangs-/Ausgangsanchlüsse periodisch auszugleichen.

Beim Betrieb von aus FET aufgebauten monolithisch integrierten Halbleiterspeichern besteht bei bestimmten Anwendungen, beispeilsweise beim Adressieren eines Pufferspeichers, die Forderung, am Ausgang einer Schaltung, z. B. einer Treiberstufe, ein bestimmtes Potential für en vergleichsweise langes Zeitintervall aufrecht zu erhalten. Diese Forderung 1äßt sich z. B. dadurch erfüllen, daß man einen FET, der durch Verbindung seiner Gate-Elektrode mit der Drain-Elektrode zu einem als Widerstand dienenden Zweipol verdrahtet wurde, mit seiner Source-Elektrode an den Ausgangsknoten der Treiberschaltung anschließt, während die beiden miteinander verbundenen anderen Elektroden des FET im Falle von n-Kanal-FET, deren Verwendung im folgenden vorausgesetzt wird, an den positiven Pol der Betriebsspannungsquelle angeschlossen werden. Über den so gebildeten Widerstand, der im Falle von monolithisch integrierten Schaltungen auch aus polykristallinem Silicium bestehen oder als diffundierter Widerstand ausgebildet sein kann, wird die Eingangskapazität der an den Ausgangsknoten der Treiberstufe angeschlossenen Schaltung nachgeladen, so daß an dieser Schaltung trotz der Leckströme der Eingangskapazität und des Treibers selbst der gewünschte Pegel für vergleichsweise lange Zeitintervalle aufrechterhalten wird.

Die beschribene Lösung weist jedoch den Nachteil auf, daß der zur einem Zweipol verdrahtete FET immer dann von einem Strom durchflossen wird und damit Verlustleistung erzeugt, wenn der Ausgangsknoten der Schaltung ein riedriges Potential aufweist.

Hier will die Erfindung Abhilfe schaffen. Die Erfindung, wie sie in dien Ansprüchen gekennzeichnet ist, löst die Aufgabe, eine Schaltung zum Nachladen des Ausgangsknotens einer Feldeffekt-Transistorschaltung anzugeben, bei der in den Zeitintervallen, in denen der Ausgangsknoten der Schaltung ein niedriges Potential aufweist, keine Verlustleistung durch die Nachladeschaltung erzeugt wird.

Die durch die Erfindung erreichten Vorteile sind in wesentlichen darin zu sehen, daß einmal bei niedrigen Potential des Ausgangsknotens der Feldeffekt-Transistorschaltung keine Verlustleistung durch die Nachladeschaltung erzeugt wird. Zum anderen entspricht das hohe Potential des Ausgangsknotens nahezu dem Wert der Betriebsspannung, da an der erfindungsgemäßen Nachladeschaltung kein Abfall der Betriebsspannung um den Wert der Schwellwertspannung der Feldeffekt-Transistoren erfolgt.

Im folgenden wird die Erfindung durch die Beschreibung zweier Ausführungsbeispiele in Verbindung mit den Zeichnungen näher erläutert, von denen zeigen:

Fig. 1 ein Schaltbild der erfindungsgemäßen FET-Schaltung zum Nachladen des Ausgangsknotens einer FET-Schaltung,

Fig. 2 das Schaltbild einer Verbesserten Schaltung gemäß der Erfindung, und

Fig. 3 das Schaltbild eines Anwendungsbeispieles für die Schaltung nach der Erfindung in einer Halbleiter-Speicherzelle.

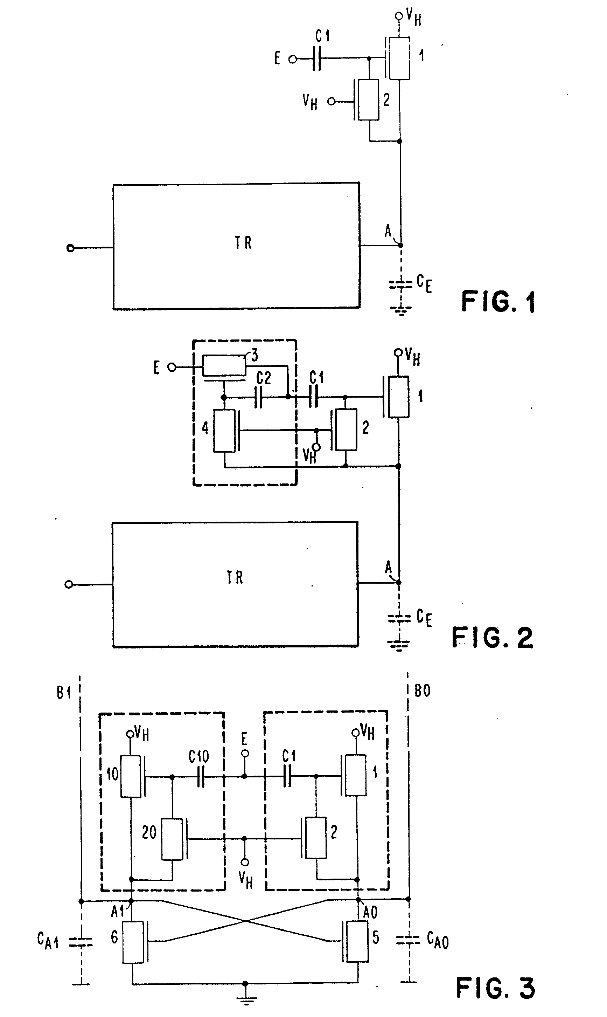

In Fig. 1 ist mit A der Ausgangsknoten einer FET-Schaltung, beispielsweise einer als Block dargestellten Treiberschaltung TR zur Ansteuerung eines Pufferspeichers bezeichnet. Die Eingangskapazität $C_E$ der an die Treiberschaltung angeschlossenen Schaltung ist gestrichelt angedeutet. Infolge von Leckströmen des Treibers und der Eingangskapazität $C_E$ muß diese Kapazität, wenn während eines vergleichsweise langen Zeitintervalls ein hohes Ausgangspotential am Ausgangsknoten A der Treiberschaltung vorhanden sein muß, periodisch nachgeladen werden. Das erst-malige Aufladen der Kapazität $C_E$ erfolgt durch einen kräftigen Impuls der Treiberschaltung TR. Bedingt durch Leckströme der Treiberschaltung TR sinkt deren Ausgangsspannung von dem Wert $V_H$ z. B. auf den um die doppelte Schwellwertspannung $2 V_T$ verminderten Wert $V_H-2 V_T$ ab. Durch die erfindungsgemäße Nachladeschaltung wird die Spannung am Ausgang A der Treiberschaltung TR auf einem Wert knapp unterhalb von $V_H$ gehalten. Dazu ist die Source-Elektrode eines FET 1 mit dem Ausgangsknoten A der Treiberschaltung verbunden, während seine Drain-Elektrode an den positiven Pol $V_H$ der Betriebsspannungsquelle angeschlossen ist. Source- und Gate-Elektrode des FET 1 sind über einen weiteren FET 2, dessen Gate-Elektrode an den positiven Pol $V_H$ der Betriebsspannungsquelle angeschlossen ist, miteinander verbunden. Die Gate-Elektrode des FET 1 ist über einen Koppelkondensator C1 mit der Eingangsklemme E der Schaltung verbunden. Das Aufrechterhalten eines positiven Ausgangspotentials am Ausgangsknoten A über ein längeres Zeitintervall wird dadurch erreicht, daß der Eingangsklemme E periodisch Steuerimpulse von der Größe der positiven Betriebsspannung $V_H$ zugeführt werden. Diese werden über den Koppelkondensator C1 der Gate-Elektrode des FET 1 zugeführt, der dadurch periodisch kurzzeitig leitend wird, weil des Potential an der Gate-Elektrode des FET 1 von etwa dem Wert $V_H$—$V_T$ auf etwa den Wert 2 $V_H$–$V_T$ springt, und dadurch der FET 1 die Eingangskapazität $C_E$ nachlädt. Der FET 2 bleibt dabei ausgeschaltet, weil seine Gate-Source-Spannung $V_{GS}$ kleiner als die Schwellwertspannung $V_T$ ist. Die Steuerimpulse erscheinen in einem solcen zeitlichen Abstand, daß die Eingangskapazität $C_E$ in der Zeit zwischen dem Auftreten zweier Steuerimpulse durch Leckströme noch nicht merklich entladen wurdge. Als Steuerimpuls kann z. B. das Selektionssignal für ein dynamisches Speicher-Chip benützt werden, das ja in regelmäßigen Zeitabständen das Chip aktivieren muß, um die dynamischen Speicherzellen wieder aufzuladen.

Wenn der Ausgangsknoten A ein niedriges Ausgangspotential aufweist, wird das Fließen eines Stromes durch den FET 1 da-durch verhindert, daß der FET 2 das Potential an der Source-Elektrode des FET 1 abfühlt und auf dessen Gate-Elektrode überträgt. Dadurch bleibt der FET 1 gesperrt, da zwischen seiner Source-Elektrode und seiner Gate-Elektrode keine seine Schwellspannung überschreitende Spannung anliegt. Daher erzeugt der FET 1 auch keine Verlustleistung, wenn der Ausgangsknoten A ein niedriges Potential aufweist. Es fließt in diesem Zustand lediglich während der Anstiegsflanke der Eingangsimpulse noch ein geringer Strom durch den FET 2. Soll auch dieser geringe Stromfluß noch verhindert werden, so läßt sich dies mit der in Fig. 2 dargestellten Schaltung erreichen.

Bei der Schaltung nach Fig. 2 tragen die Schaltungselemente, die denen der Fig. 1 entsprechen, die gleichen Bezugszeichen.

Der Unterschied der Fig. 2 gegenüber der Fig. 1 besteht in der Einfügung des von einer Strichlinie umgebenen Schaltungsteiles. Dieser besteht aus einem weiteren FET 3, dessen Drain-Elektrode mit der Eingangsklemme E verbunden ist. Die Source-Elektrode des FET 3 ist an die eine Elektrode des Kondensators C1 angeschlossen und über einen Kondensator C2 mit seiner Gate-Elektrode verbunden. Über einen weiteren FET 4, dessen Gate-Elektrode mit dem positiven Pol $V_H$ der Versorgungsspannung verbunden ist, ist die Gate-Elektrode des FET 3 mit dem Ausgangsknoten A verbunden.

Die Wirkungsweise der Schaltung nach Fig. 2 ist folgende: Weist der Ausgangsknoten A, bei dem es sich wieder um den Ausgangsknoten einer FET-Treiberschaltung handeln soll, ein niedriges Potential auf, so wird dieses Potential durch den leitenden FET 4 sur Gate-Elektrode des FET 3 übertragen. Erscheint jetzt einer der periodisch wiederkehrenden Eingangsimpulse, dressen Größe der positiven Betriebsspannung entspricht, so wird der Eingangsimpuls von dem FET 3 nicht zum Kondensator C1 übertragen, da der FET 3 nichtleitend ist, weil seine Gate-Source-Spannung $V_{GS}$ kleiner als die Schwellspannung $V_T$ ist.

Weist der Ausgangsknoten A jedoch das hohe Ausgangspotential auf, so wird auch dieses Potential über den leitenden FET 4 zur Gate-Elektrode des FET 3 übertragen. Die Gate-Kapazität des FET 3 wird somit auf das hohe Ausgangspotential vorgeladen, das höchstens um den Wert der Schwellspannung $V_T$ absinken darf, soll die Funktion der an den Ausgangsknoten A angeschlossenen Schaltung nicht beeinträchtigt werden. Erscheint jetzt wieder ein Eingangsimpuls an der Drain-Elektrode des FET 3 und über den Kondensator C2 auch an seiner Gate-Elektrode, so wird der Eingangsimpuls von dem FET 3 voll durchgeschaltet, da jetzt aufgrund der vorgeladenen Gate-Kapazität die Gate-Source-Spannung $V_{GS}$ wesentlich größer als die Schwellspannung $V_T$ ist. Uber den Kondensator C1 gelangt der Eingangsimpuls zur Gate-Elektrode des FET 1 und macht diesen leitend, so daß die Eingangskapazität $C_E$ der an den Ausgangsknoten A angeschlossenen Schaltung periodisch nachgeladen wird. Daher behält das Potential am Ausgangsknoten A für eine vergleichsweise lange Zeitspanne seinen hohen Wert bei.

Fig. 3 zeigt das Schaltbild eines Anwendungsbeispieles für die Schaltung nach Fig. 1 der Erfindung. As handelt sich um ein aus Feldeffekt-Transistoren aufgebautes Flip-Flop, das beispielsweise in einem Pufferspeicher Verwendung finden kann. Bei dem Flip-Flop nach Fig. 3 sind die beiden Lastelemente, die üblicherweise durch je einen FET gebildet werden, bei dem die Gate-Elektrode mit der Drain-Elektrode verbunden ist, durch je eine von einer Strichlinie umschlossene Schaltung nach Fig. 1 ersetzt. Die Schaltungselemente, die im rechten Zweig des Flip-Flops das Lastelement ersetzen, sind wie in Fig. 1 bezeichnet. Die entsprechenden Schaltungselemente im linken Zweig sind außerdem durch eine hinzugesetzte Null gekennzeichnet. Die beiden Schaltelemente des Flip-Flops sind mit 5 bzw. 6, die Schreib/Leseleitungen mit B0 bzw. B1 und die beiden Ausgangsknoten des Flip-Flops mit A0 bzw. A1 bezeichnet. Die an den beiden Ausgangsknoten A0 bzw. A1 vorhandenen Kapazitäten sind gestrichtelt angedeutet und mit $C_{A0}$ bzw. $C_{A1}$ bezeichnet.

Das Flip-Flop befindet sich beispielsweise in dem Zustand, bei dem der Ausgangsknoten A1 niedriges und der Ausgangsknoten A0 hohes Potential aufweist. Soll dieser Zustand für ein vergleichsweise langes Zeitintervall beibehalten werden, so wird das Entladen des Ausgangsknotens A0 infolge von Leckströmen der Kapazität $C_{A0}$ durch deren periodisches Nachladen aufgrund der an der Eingangsklemme E zugeführten Impulse ausgeglichen. Ein Stromfluß vom positiven Pol $V_H$ der Betriebsspannungsquelle über den FET 10 im linken Zeig des Flip-Flops zum Ausgangsknoten A1 wird durch den FET 20 verhindert, wie das bei der Beschreibung der Fig. 1 erläutert wurde.

Die Lastelemente eines Flip-Flops aus Feldeffekt-Transistoren könen selbstverständlich auch durch Schaltungen nach Fig. 2 ersetzt werden.

Ferner ist es möglich, die beschriebenen, mit n-Kanal-Feldeffekt-Transistoren arbeitenden Schaltungen mit p-Kanal-Feldeffekt-Transistoren aufzubauen bei entsprechender Umpolung der Betriebsspannungen.

## Patentansprüche

1. Schaltung zum Nachladen des Ausgangsknotens (A) einer Feldeffekt-Transistorschaltung, bei der die Source-Elektrode eines ersten Feldeffekt-Transistors (1) an den Ausgangsknoten (A) der Schaltung angeschlossen ist, und seine Drain-Elektrode mit dem nicht an das Bezugspotential angeschlossenen Pol der Betriebsspannungsquelle ($V_H$) verbunden ist, während seine Gate-Elektrode an die Eingangsklemme (E) angeschlossen ist, dadurch gekennzeichnet, daß die Gate-Elektrode des ersten. Feldeffekt-Transistors über einen Kondensator (C1) an die Eingangsklemme (E) angeschlossen ist, und daß ein zweiter Feldeffekt-Transistor (2) vorgesehen ist, dessen Gate-Elektrode mit dem nicht an das Bezugspotential angeschlossenen Pol der Betriebsspannungsquelle ($V_H$) verbunden ist und der die Gate-Elektrode des ersten Feldeffekt-Transistors mit dessen Source-Elektrode Verbindet.

2. Schaltung nach Anspruch 1, dadurch gekennzeichnet, daß zwischen der Eingangsklemme (E) und dem Kondensator (C1) ein dritter Feldeffekt-Transistor (3) angeordnet ist, dessen Drain-Elektrode mit der Eingangsklemme (E) und dessen Gate-Elektrode zum einen über einen weiterein Kondensator (C2) mit seiner Source-Elektrode und zum anderen über einen vierten Feldeffekt-Transistor (4), dessen Gate mit dem nicht an das Bezugspotential angeschlossenen Pol der Betriebsspannungsquelle ($V_H$) verbunden ist, an den Ausgangsknoten angeschlossen ist.

3. Verwendung eiener Schaltung nach den Ansprüchen 1 oder 2, als Lastelement in jedem Zweig eines Flip-Flops.

## Claims

1. A circuit for recharging the output node (A) of a field-effect transistor circuit, wherein the source electrode of a first field-effect transistor (1) is connected to the output node (A) of the circuit and its drain electrode is connected to the pole of the operating voltage source ($V_H$) not linked to the reference potential, while its gate electrode is connected to the input terminal (E), characterized in that the gate electrode of the first field-effect transistor is connected to the input terminal (E) through a capacitor (C1), and that a second field-effect transistor (2) is provided having its gate electrode connected to the pole of the operating voltage source ($V_H$) not linked to the reference potential and connecting the gate electrode of the first field-effect transistor to its source electrode.

2. The circuit according to claim 1 characterized in that between the input terminal (E) and the capacitor (C1) a third field-effect transistor (3) is arranged having its drain electrode connected to the input terminal (E) and its gate electrode connected to its source electrode through a further capacitor (C2) as well as to the output node through a fourth field-effect transistor (4) whose gate is connected to the pole of the operating voltage source ($V_H$) not linked to the reference potential.

3. Use of the circuit according to claim 1 or 2 as a load element in each branch of a flip-flop.

## Revendications

1. Circuit pour recharger le noeud de sortie (A) d'un circuit à transistors à effet de champ, dans lequel l'électrode source d'un premier transistor à effet de champ (1) est connectée au noeud de sortie (A) du circuit et son électrode drain est connectée au pôle de la source de tension de fonctionnement ($V_H$) non raccordé au potentiel de référence, tandis que son électrode de port est connectée à la borne d'entrée (E), caractérisé en ce que: l'électrode de porte du premier transistor à effet de champ est connectée à la borne d'entrée (E) au travers d'une capacité (C1), et en ce qu'est prévu un deuxiéme transistor à effet de champ (2) dont l'électrode de porte est connectée au pole de la source de tension de fonctionnement ($V_H$) non raccordé au potentiel de référence et qui connecte l'électrode de porte du premier transistor à effet de champ à l'électrode source de celui-ci.

2. Circuit selon la revendication 1, caractérisé en ce qu'entre la borne d'entrée (E) et la capacité (C1), est disposé un troisième transistor à effet de champ (3) dont l'électrode de drain est connectée à la borne d'entrée (E) et l'électrode de porte connectée d'un côté à son électrode de source au travers d'une autre capacité (C2) et d'un autre côté au noeud de sortie au travers d'un quatrième transistor à effet de champ (4) dont la porte est connectée au pôle de la source de tension de fonctionnement ($V_H$) non raccordé au potentiel de référence.

3. Utilisation du circuit selon la revendication 1 ou 2 en tant qu'élément de charge dans chaque branche d'une bascule.

FIG. 1

FIG. 2

FIG. 3